(19) Europäisches Patentamt / European Patent Office / Office européen des brevets

(11) **EP 3 595 171 B1**

(12) **FASCICULE DE BREVET EUROPEEN**

(45) Date de publication et mention
de la délivrance du brevet:
**27.01.2021 Bulletin 2021/04**

(51) Int Cl.:
***H03G 3/30*** *(2006.01)*

(21) Numéro de dépôt: **19185885.1**

(22) Date de dépôt: **11.07.2019**

(54) **PROCÉDÉ DE CONTRÔLE D'UN GAIN**

KONTROLLVERFAHREN EINER VERSTÄRKUNG

METHOD FOR CONTROLLING A GAIN

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **13.07.2018 FR 1856464**

(43) Date de publication de la demande:
**15.01.2020 Bulletin 2020/03**

(73) Titulaire: **Commissariat à l'Energie Atomique et
aux Energies
Alternatives
75015 Paris (FR)**

(72) Inventeur: **LAUGEOIS, Marc
38054 Grenoble Cedex 09 (FR)**

(74) Mandataire: **Cabinet Beaumont
4, Place Robert Schuman
B.P. 1529
38025 Grenoble Cedex 1 (FR)**

(56) Documents cités:
**EP-A1- 2 533 426       WO-A1-2012/152549
US-A1- 2016 013 816**

**Description**

Domaine

La présente description concerne les systèmes de traitement numérique de l'information, et plus particulièrement leur calibration. La présente description concerne encore plus particulièrement les procédés de contrôle d'un gain d'un amplificateur à gain variable compris dans ces systèmes.

Exposé de l'art antérieur

Un système de traitement, par exemple de réception d'un signal analogique comprend généralement au moins un amplificateur et un convertisseur analogique-numérique permettant d'échantillonner le signal reçu par le système. L'amplificateur permet d'adapter l'amplitude du signal reçu à une plage de travail du convertisseur analogique-numérique. L'amplificateur peut être un amplificateur à gain variable, c'est-à-dire un amplificateur dont le gain peut être modulé, par exemple en fonction de l'amplitude du signal reçu et/ou en fonction de la plage de linéarité du convertisseur analogique-numérique.

Il serait souhaitable d'améliorer certains aspects des procédés de calibration d'une chaîne de réception et, plus particulièrement, certains aspects des procédés de détermination de gain déjà existants. Il est mentionné la demande de brevet US 2006/145902 A1 qui divulgue un système permettant de recevoir un signal analogique et de le convertir en numérique avec un facteur de gain variable.

Résumé

L'invention est décrite par le contenu de la revendication indépendante.

L'invention prévoit un procédé de calibration d'une chaîne de réception comprenant un amplificateur d'entrée d'un convertisseur analogique-numérique, et comportant les étapes successives suivantes : déterminer un gain de repos en fonction de la puissance moyenne du bruit présent sur un signal numérique issu dudit convertisseur ; et fixer le gain de l'amplificateur d'entrée audit gain de repos lorsque la puissance moyenne dudit signal numérique est inférieure à un premier seuil.

Selon l'invention, le gain est ajusté en ajoutant un pas de réglage de gain déterminé en fonction de la puissance moyenne du signal numérique lorsque la puissance moyenne du signal numérique est supérieure à un deuxième seuil.

Selon un mode de réalisation, pour calculer le pas de réglage de gain, la puissance moyenne du signal numérique est calculée en fonction d'une puissance linéaire du signal numérique.

Selon un mode de réalisation, la puissance linéaire Plin est calculée selon la formule :

$$Plin = \frac{I^2 + Q^2}{K}$$

dans lequel :

I est la partie imaginaire du signal numérique ;
Q est la partie réelle du signal numérique ; et
K est un facteur conditionnant le nombre de bits sur lequel la puissance linéaire Plin est codée.

Selon un mode de réalisation, le nombre K désigne les bits de poids faible pour lesquels la puissance moyenne du signal numérique est non mesurable.

Selon un mode de réalisation, la puissance moyenne est calculée en utilisant un filtre à réponse impulsionnel infini.

Selon un mode de réalisation, la puissance moyenne est convertie en une puissance moyenne logarithmique.

Selon un mode de réalisation, la puissance moyenne logarithmique Plog est obtenue à partir d'une table dont les éléments sont calculés selon la formule :

$$Plog = \frac{2^{N'} - 1}{\ln(2^{N'} - 1)} \ln(Pmoy)$$

dans lequel N' est le nombre de bits sur lequel la puissance moyenne logarithmique est codée ; et

Pmoy représente la puissance moyenne du signal numérique.

Selon un mode de réalisation, le pas de réglage de gain ginc est calculé selon la formule :

$$ginc = \frac{Pref - Plog}{[1dB]}$$

où Pref est une puissance de référence.

Selon un mode de réalisation, la puissance de référence est déterminée en fonction de la puissance maximale atteinte par le signal numérique.

Selon un mode de réalisation, la chaîne de réception transmet des données par paquets.

Selon un mode de réalisation, le gain de l'amplificateur est ajusté après une seule itération.

Selon un mode de réalisation, le gain de l'amplificateur est ajusté après au moins une itération.

Selon un mode de réalisation, le nombre d'itérations est égal à un ou deux.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, sous forme de schéma bloc, un mode de réalisation d'une partie d'une chaîne de réception ;
la figure 2 représente, sous forme d'un diagramme d'états, un mode de réalisation d'un procédé de calibration de la chaîne de réception de la figure 1 ;
la figure 3 représentent deux chronogrammes (a) et (b) illustrant, respectivement, la puissance moyenne d'un signal et le gain d'un amplificateur à gain variable ;
la figure 4 représente, sous forme de schéma bloc, un mode de réalisation d'un procédé de détermination d'un pas de réglage de gain ; et
la figure 5 illustre un exemple de mise en oeuvre d'une étape du procédé de la figure 4.

Description détaillée

De mêmes éléments ont été désignés par de mêmes références dans les différentes figures. Par souci de clarté, seuls les éléments utiles à la compréhension des modes de réalisation décrits ont été représentés et sont détaillés. En particulier, le fonctionnement d'un convertisseur analogique-numérique ne sera pas détaillé, en effet les modes de réalisation décrits s'adaptent à des convertisseurs analogique-numérique usuels.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc. Sauf précision contraire, les expressions "approximativement", "sensiblement", "environ", et "de l'ordre de" signifient à 10 % près, de préférence à 5 % près.

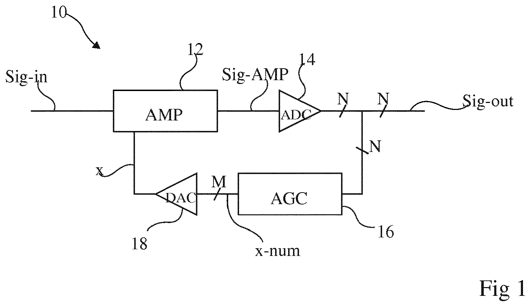

La figure 1 est un schéma bloc simplifié illustrant un mode de réalisation d'une chaîne de réception 10.

La chaîne de réception 10 reçoit, en entrée, un signal analogique Sig-in et fournit, en sortie, un signal numérique Sig-out. La chaîne de réception 10 est destinée à la réception de données transmises par paquets.

Le signal analogique Sig-in est, dans un premier temps, traité par un amplificateur 12 (AMP). L'amplificateur 12 est un amplificateur à gain variable, c'est-à-dire un amplificateur dont le gain peut être modifié par une commande, par exemple une commande analogique x. L'amplificateur 12 amplifie le signal analogique Sig-in et fournit un signal analogique Sig-AMP à un convertisseur analogique-numérique 14 (ADC). Plus particulièrement, l'amplificateur 12 adapte l'amplitude du signal analogique Sig-in afin de la faire correspondre à une plage de travail du convertisseur analogique-numérique 14. Le convertisseur analogique-numérique 14 fournit, en sortie, le signal numérique Sig-out codé sur un nombre N de bits.

La chaîne de réception 10 comprend en outre un circuit 16 exécutant un algorithme de contrôle de gain AGC. L'algorithme AGC reçoit, en entrée, le signal numérique Sig-out et fournit, en sortie, une commande numérique x-num codée sur un nombre M de bits. L'algorithme AGC permet de déterminer, à partir du signal numérique Sig-out, la commande numérique x-num. La commande numérique x-num est convertie en la commande analogique x par un convertisseur numérique-analogique 18 (DAC) adapté à convertir un signal numérique codé sur un nombre M de bits en un signal analogique. La commande analogique x est ensuite transmise à l'amplificateur 12 pour contrôler son gain. Les nombres N et M peuvent être différents ou égaux.

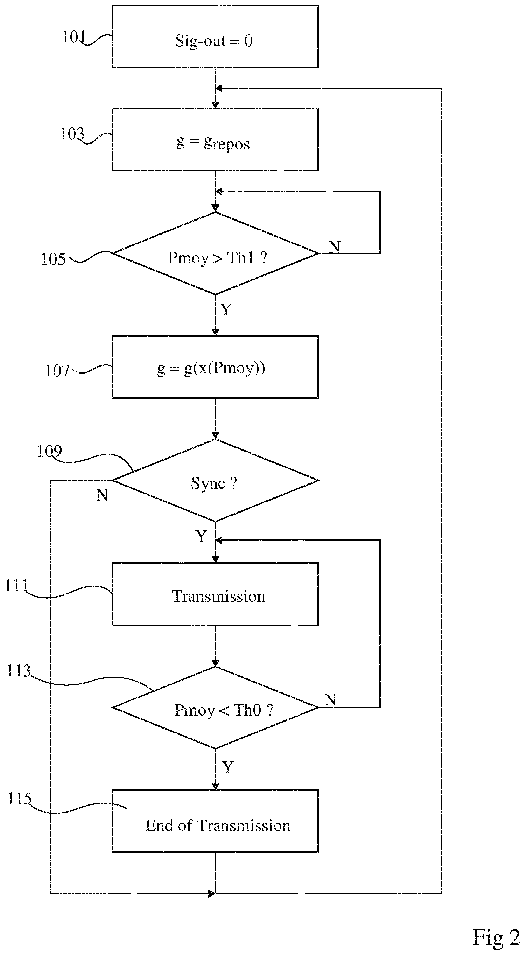

La figure 2 est un schéma bloc illustrant le fonctionnement d'un mode de réalisation de l'algorithme de contrôle de gain AGC.

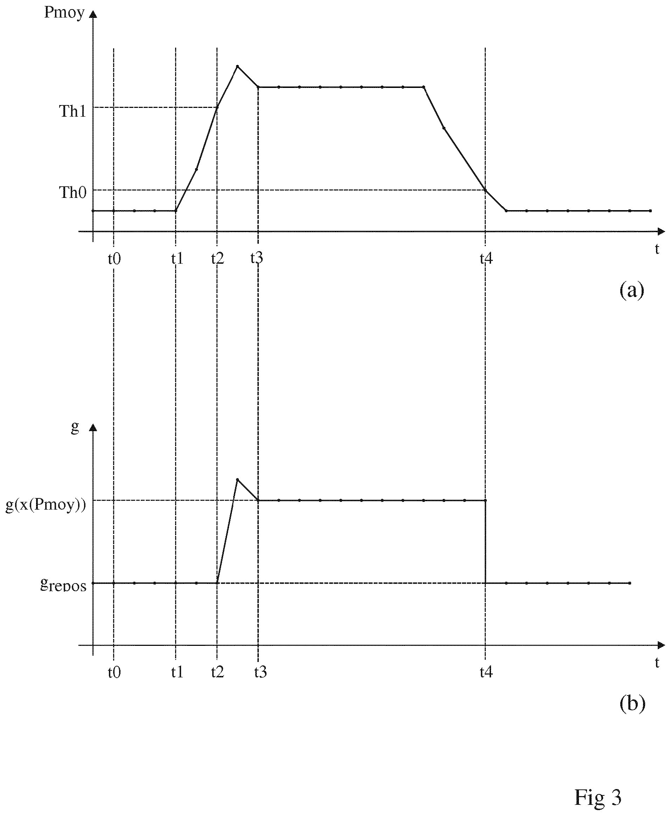

La figure 3 représente deux chronogrammes (a) et (b) illustrant des exemples d'allures, respectivement, de la puissance moyenne Pmoy du signal numérique Sig-out et du gain g de l'amplificateur 12.

A un état de repos (figure 2, bloc 101, Sig-out=0), entre un instant t0 et un instant t1 (figure 3), la chaîne ne reçoit pas de paquet de données. Cet état de repos peut par exemple avoir lieu avant la transmission d'un paquet, ou entre deux transmissions d'un paquet. Le signal numérique Sig-out est considéré comme étant à un état bas, plus particulièrement, sa puissance moyenne Pmoy est inférieure à un seuil Th0. Le seuil Th0 correspond à un seuil de fin de trame ou à un seuil d'absence de signal. Le seuil Th0 est défini à la conception-fabrication. Le seuil Th0 est par exemple fixé à 0 Watt.

A l'état de repos, l'algorithme AGC fournit une commande numérique x-num($g_{repos}$) qui, une fois convertie en une commande analogique x($g_{repos}$) par le convertisseur numérique-analogique 18, fixe le gain g (figure 3, chronogramme (b)) de l'amplificateur 12 à une valeur de repos $g_{repos}$ (figure 2, bloc 103, g=$g_{repos}$). Cette valeur de repos $g_{repos}$, ou gain de repos, est définie, à la conception-fabrication, hors d'une zone de saturation du convertisseur analogique-numérique 14. Plus particulièrement, le gain de repos $g_{repos}$ est déterminé à partir de la puissance moyenne du signal Sig-out lorsqu'il ne transmet pas de paquet, c'est-à-dire lorsque la puissance moyenne du signal Sig-out ne correspond qu'à une puissance moyenne du bruit présent sur le signal Sig-out. À titre de variante, l'algorithme AGC peut comprendre une étape permettant de régler plus finement le gain de repos $g_{repos}$ dans un processus d'adaptation sur plusieurs transmissions de paquets.

Le circuit 12 compare alors (figure 2, bloc 105, Pmoy>Th1 ?) la puissance moyenne Pmoy du signal Sig-out à une valeur de seuil Th1 afin de détecter un début de paquet. Le seuil Th1 correspond à un seuil de début de trame. Le seuil Th1 est supérieur au seuil Th0. A titre d'exemple, le seuil Th1 peut être défini comme étant égal à la moitié du rapport signal sur bruit (SNR) du signal numérique Sig-out pendant l'initialisation de la chaîne 10. Selon un autre exemple, le seuil Th1 peut être inférieur à la moitié du rapport signal sur bruit du signal numérique Sig-out de façon à détecter le paquet de données au plus tôt.

Tant que la puissance moyenne du signal Sig-out est inférieure à la valeur Th1 (figure 2, sortie N du bloc 105), c'est-à-dire jusqu'à un instant t2 postérieur à l'instant t1 (figure 3), le gain de l'amplificateur 12 reste fixé à la valeur de repos $g_{repos}$ car on considère une absence de paquet.

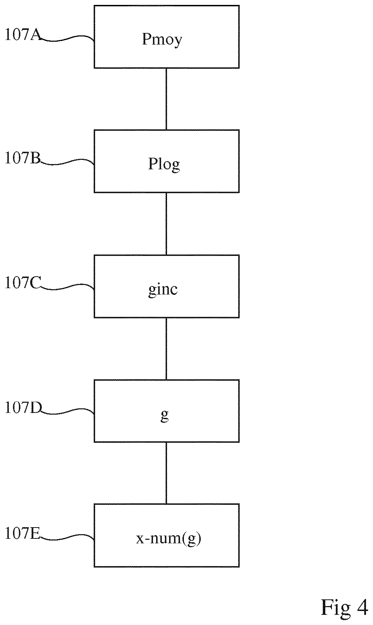

Lorsque la puissance moyenne Pmoy du signal numérique Sig-out dépasse la valeur seuil Th1 (figure 2, sortie Y du bloc 105) (figure 3, instant t2), l'algorithme passe alors à une étape de détermination de la commande de gain (figure 2, bloc 107, g=g(x(Pmoy))). Plus particulièrement, l'algorithme AGC détermine une nouvelle commande numérique x-num(Pmoy) qui, une fois convertie en une commande analogique x(Pmoy) par le convertisseur 18, fixe le gain de l'amplificateur 12 à une valeur de gain g(x(Pmoy)). Cette valeur de gain g(x(Pmoy)) est déterminée en fonction de la puissance moyenne Pmoy du signal numérique Sig-out. Un exemple plus détaillé de procédé de détermination de la valeur de gain g(x(Pmoy)) sera décrit en relation avec la figure 4.

Une fois le gain de l'amplificateur 12 fixé, l'algorithme passe à une étape temporisée d'attente de synchronisation du signal numérique Sig-out (figure 2, bloc 109, Sync ?) entre l'instant t2 et un instant t3 (figure 3).

Si au bout de la fenêtre de temporisation la synchronisation n'aboutit pas (figure 2, sortie N du bloc 109), le circuit considère que la transmission d'un paquet n'a pas eu lieu et revient à l'état de repos (figure 2, bloc 103). Ce cas n'est pas illustré par la figure 3.

Si la synchronisation aboutit (figure 2, sortie Y du bloc 109) la transmission du paquet commence (figure 2, bloc 111, Transmission) à l'instant t3 (figure 3).

La puissance du signal Sig-out est alors comparée au seuil Th0 (figure 2, bloc 105, Pmoy<Th0 ?).

Tant que la puissance moyenne du signal Sig-out est supérieure à la valeur seuil Th0 (figure 2, sortie N du bloc 105) (représenté en figure 3 entre les instants t2 et t4) le gain de l'amplificateur 12 reste fixé à la valeur de gain g(x(Pmoy)) dépendant de la puissance moyenne du signal car la transmission du paquet n'est pas terminée.

Lorsque la puissance moyenne Pmoy du signal numérique Sig-out diminue jusqu'à devenir inférieure au seuil Th0 (figure 2, Sortie Y du bloc 113) (figure 3, instant t4), la transmission du paquet se termine (figure 2, bloc 115, End of transmission).

L'algorithme revient alors dans la situation du bloc 103.

Un avantage de l'algorithme de contrôle de gain AGC décrit en relation avec les figures 2 et 3 est que l'amplitude du signal analogique Sig-AMP, fourni au convertisseur analogique-numérique 14, n'est jamais dans une zone de saturation du convertisseur 14.

Un autre avantage de cet algorithme est qu'il permet une adaptation rapide du gain de l'amplificateur au moment où un paquet est détecté sur récepteur, et ce sans connaissance de l'instant d'arrivée du paquet.

La figure 4 est un schéma bloc illustrant plus en détail des opérations de calcul réalisées lors de l'étape 107 de détermination de la commande de gain.

A une étape 107A (Pmoy), la puissance moyenne Pmoy du signal numérique Sig-out est calculée. Pour cela, la puissance linéaire Plin du signal numérique Sig-out est mesurée puis moyennée en utilisant, par exemple, un filtre à réponse pulsionnelle infinie du premier ordre.

A titre d'exemple, la puissance linéaire Plin du signal numérique Sig-out est mesurée en appliquant la formule suivante :

$$Plin = \frac{I^2 + Q^2}{K}$$

dans lequel :

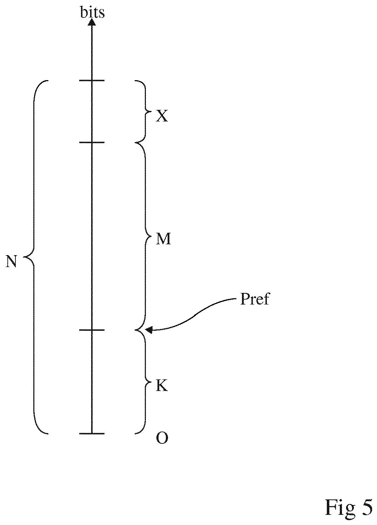

I est la partie imaginaire du signal numérique Sig-out ;
Q est la partie réelle du signal numérique Sig-out ; et
K est un facteur conditionnant le nombre de bits sur lequel la puissance linéaire est codée, ce facteur est décrit plus en détail en relation avec la figure 5.

A une étape 107B (Plog), la puissance moyenne Pmoy déterminée à l'étape 107A est convertie en une puissance moyenne logarithmique Plog. A titre d'exemple, la puissance moyenne logarithmique Plog est obtenue par une table logarithmique dont les éléments sont calculés par la formule suivante :

$$Plog = \frac{2^{N'} - 1}{\ln(2^{N'} - 1)} \ln(Pmoy)$$

dans lequel N' est le nombre de bits sur lequel la puissance logarithmique Plog est codée.

La table logarithmique est par exemple stockée dans une mémoire appartenant au circuit 16.

A une étape 107C (ginc), un pas de réglage de gain ginc est déterminé à partir de la puissance moyenne logarithmique Plog déterminée à l'étape 107B. A titre d'exemple, le pas ginc en dB est calculé par la formule suivante :

$$ginc = Pref - Plog$$

dans lequel Pref est une puissance logarithmique de référence définie par l'utilisateur.

A titre de variante, la puissance logarithmique de référence Pref peut être définie en fonction de la puissance maximale atteinte par le signal numérique Sig-out.

A une étape 107D (g), la valeur du gain g, ou g(x(Pmoy)), permettant de régler l'amplificateur 12, est déterminée en fonction du pas de réglage de gain ginc déterminé à l'étape 107C. Pour cela, la valeur du pas de réglage de gain ginc est ajoutée à la valeur du gain déjà programmé de l'amplificateur 12. Plus particulièrement, pendant l'état de repos du bloc 101, l'amplificateur est programmé avec un gain égal au gain de repos $g_{repos}$, et à l'instant suivant, le gain de l'amplificateur 12 est égal à la somme du gain de repos et du pas de réglage de gain ginc. Pendant l'étape 107, le gain g peut être déterminé suite à plusieurs itérations, par exemple une à dix itérations, de préférence une ou deux itérations. Autrement dit, le gain g(n+1) adapté de rang n+1 est égal à :

$$g(n + 1) = g(n) + ginc$$

dans lequel g(n) représente le gain courant de rang n.

Un avantage d'utiliser plusieurs itérations pour déterminer le gain g est que cela permet d'avoir un réglage plus fin du gain g. De plus, dans le cas où le rapport signal à bruit est inférieur à environ 36 dB, une seule itération est nécessaire.

A une étape 107E (x-num(g)), la commande numérique x-num(g), envoyée par l'algorithme de contrôle de gain AGC au convertisseur numérique-analogique 18, est déterminée en fonction de la valeur de gain g déterminée à l'étape 107D. Pour cela, on utilise par exemple la formule suivante :

$$x - num(g) = \frac{2^M - 1}{g_{min} - g_{max}} \cdot \frac{V_{max} - V_{min}}{V_{max}} \cdot \left( g - \frac{g_{min} \cdot V_{max} - g_{max} \cdot V_{min}}{V_{max} - V_{min}} \right)$$

dans lequel :

M est le nombre de bits sur lequel le convertisseur numérique-analogique code la commande numérique x-num(g) ;
$g_{min}$ est le gain minimal que peut fournir l'amplificateur 12 ;
$g_{max}$ est le gain maximal que peut fournir l'amplificateur 12 ;
$V_{min}$ est la tension minimale que peut fournir l'amplificateur 12 ; et
$V_{max}$ est la tension maximale que peut fournir l'amplificateur 12.

La figure 5 illustre schématiquement la détermination du facteur K utilisé pour le calcul de la puissance linéaire Plin définie en relation avec la figure 4.

La figure 5 représente une échelle schématisant le cas où les convertisseurs 14 et 18, respectivement, code et décode, des signaux avec des nombres de bits N et M différents et, plus particulièrement, le cas où le nombre de bits M est inférieur au nombre de bits N. Ainsi le signal Sig-out est codé sur N bits par le convertisseur analogique-numérique et sa puissance moyenne Pmoy est codée sur M bits. Pour abaisser le nombre de bits N sur lequel le signal Sig-out est codé, les N bits du signal Sig-out sont tronquées de K bits de poids faible et de X bits de poids fort non utilisés.

Le nombre X est déterminé empiriquement en fonction de la forme du signal Sig-out. A titre d'exemple, quand le signal Sig-out est un signal de type gaussien, le nombre X vaut 3. A titre d'exemple, quand le signal Sig-out est un signal de type créneau, le nombre X vaut 1. A titre d'exemple, le nombre X est égal à 2.

Le nombre K regroupe toutes les valeurs de signaux Sig-out trop faibles pour être considérées utiles. Ainsi, on élimine les puissances linéaires Plin trop faibles pour être mesurées. A titre d'exemple, le nombre K est défini par la formule suivante :

$$K = 2^{2N-M-1-X} - 1$$

Des modes de réalisation particuliers ont été décrits. Diverses variantes et modifications combinables apparaîtront à l'homme de l'art. En particulier, l'algorithme de contrôle de gain AGC pourrait comprendre un procédé d'auto-calibration du gain de repos $g_{repos}$.

En outre, la mise en oeuvre pratique des modes de réalisation qui ont été décrits est à la portée de l'homme du métier en utilisant les indications fonctionnelles données ci-dessus.

## Revendications

1. Procédé de calibration d'une chaîne de réception (10) comprenant un amplificateur d'entrée (12) d'un convertisseur analogique-numérique (14), et comportant les étapes successives suivantes :

déterminer un gain de repos ($g_{repos}$) en fonction de la puissance moyenne du bruit présent sur un signal numérique (Sig-out) issu dudit convertisseur (14) ; et
fixer le gain (g) de l'amplificateur d'entrée (12) audit gain de repos ($g_{repos}$) lorsque la puissance moyenne (Pmoy) dudit signal numérique (Sig-out) est inférieure à un premier seuil (Th0),
dans lequel le gain (g) est ajusté en ajoutant un pas de réglage de gain (ginc) déterminé en fonction de la puissance moyenne du signal numérique (Sig-out) lorsque la puissance moyenne (Pmoy) du signal numérique (Sig-out) est supérieure à un deuxième seuil (Th1).

2. Procédé la revendication 1, dans lequel, pour calculer le pas de réglage de gain (ginc), la puissance moyenne (Pmoy) du signal numérique (Sig-out) est calculée en fonction d'une puissance linéaire (Plin) du signal numérique (Sig-out).

3. Procédé selon la revendication 2, dans lequel la puissance linéaire Plin est calculée selon la formule :

$$Plin = \frac{I^2 + Q^2}{K}$$

dans lequel :

I est la partie imaginaire du signal numérique (Sig-out) ;

Q est la partie réelle du signal numérique (Sig-out) ; et

K est un facteur conditionnant le nombre de bits sur lequel la puissance linéaire Plin est codée.

4. Procédé selon la revendication 3, dans lequel le nombre K désigne les bits de poids faible pour lesquels la puissance moyenne (Pmoy) du signal numérique (Sig-out) est non mesurable.

5. Procédé selon l'une quelconque des revendications 1 à 4, dans lequel la puissance moyenne (Pmoy) est calculée en utilisant un filtre à réponse impulsionnel infini.

6. Procédé selon l'une quelconque des revendications 1 à 5, dans lequel la puissance moyenne (Pmoy) est convertie en une puissance moyenne logarithmique Plog.

7. Procédé selon la revendication 6, dans lequel la puissance moyenne logarithmique Plog est obtenue à partir d'une table dont les éléments sont calculés selon la formule :

$$Plog = \frac{2^{N'} - 1}{\ln(2^{N'} - 1)} \ln(Pmoy)$$

dans lequel N' est le nombre de bits sur lequel la puissance moyenne logarithmique (Plog) est codée ; et Pmoy représente la puissance moyenne (Pmoy) du signal numérique (Sig-out).

8. Procédé selon la revendication 6 ou 7, dans lequel le pas de réglage de gain ginc est calculé selon la formule :

$$ginc = \frac{Pref - Plog}{[1dB]}$$

où Pref est une puissance de référence.

9. Procédé selon la revendication 8, dans lequel la puissance de référence (Pref) est déterminée en fonction de la puissance maximale atteinte par le signal numérique (Sig-out).

10. Procédé selon l'une quelconque des revendications 1 à 9, dans lequel la chaîne de réception (10) reçoit des données transmises par paquets.

11. Procédé selon l'une quelconque des revendications 1 à 10, dans lequel le gain (g) de l'amplificateur (12) est ajusté après une seule itération.

12. Procédé selon l'une quelconque des revendications 1 à 11, dans lequel le gain (g) de l'amplificateur (12) est ajusté après au moins une itération.

13. Procédé selon la revendication 12, dans lequel le nombre d'itérations est égal à un ou deux.

**Patentansprüche**

1. Kalibrierverfahren zum Kalibrieren einer Empfangskette (10), die einen Eingangsverstärker (12) eines Analog-Digital-Wandlers (14) umfasst, wobei das Kalibrierverfahren die folgenden aufeinanderfolgenden Schritte umfasst:

Bestimmen einer Ruheverstärkung ($g_{repos}$) als Funktion der mittleren Leistung von auf einem, von dem Wandler (14) ausgegebenen, digitalen Signal (Sig-out) vorhandenem Rauschen; und
Einstellen der Verstärkung (g) des Eingangsverstärkers (12) auf die Ruheverstärkung ($g_{repos}$), wenn die mittlere Leistung (Pmoy) des digitalen Signals (Sig-out) niedriger als ein erster Schwellenwert (Th0) ist, wobei die Verstärkung (g) durch Addieren eines Verstärkungseinstellungsinkrements (ginc) eingestellt wird, das als eine Funktion der mittleren Leistung des digitalen Signals (Sig-out) bestimmt wird, wenn die mittlere Leistung (Pmoy) des digitalen Signals (Sig-out) größer als ein zweiter Schwellenwert (Th1) ist.

2. Verfahren nach Anspruch 1, wobei zur Berechnung des Verstärkungseinstellungsinkrements (ginc) die mittlere Leistung (Pmoy) des digitalen Signals (Sig-out) als eine Funktion einer linearen Leistung (Plin) des digitalen Signals (Sig-out) berechnet wird.

3. Verfahren nach Anspruch 2, wobei die lineare Leistung Plin gemäß der Formel berechnet wird:

$$Plin = \frac{I^2 + Q^2}{K}$$

wobei:

I der Imaginärteil des digitalen Signals (Sig-out) ist;
Q der Realteil des digitalen Signals (Sig-out) ist; und
K ein Faktor ist, der die Anzahl der Bits bedingt, auf denen die lineare Leistung Plin kodiert ist.

4. Verfahren nach Anspruch 3, wobei die Anzahl K die niedrigstwertigen Bits bezeichnet, für die die mittlere Leistung (Pmoy) des digitalen Signals (Sig-out) nicht messbar ist.

5. Verfahren nach einem der Ansprüche 1 bis 4, bei dem die mittlere Leistung (Pmoy) unter Verwendung eines Filters mit unbegrenztem Impulsansprechverhalten berechnet wird.

6. Verfahren nach einem der Ansprüche 1 bis 5, bei dem die mittlere Leistung (Pmoy) in eine logarithmische mittlere Leistung Plog umgewandelt wird.

7. Verfahren nach einem der Ansprüche 6, wobei die logarithmische mittlere Leistung Plog aus einer Tabelle erhalten wird, deren Elemente gemäß der Formel berechnet werden:

$$Plog = \frac{2^{N'} - 1}{\ln(2^{N'} - 1)} \ln(Pmoy)$$

wobei N' die Anzahl der Bits ist, auf denen die logarithmische mittlere Leistung (Plog) kodiert ist; und
Pmoy die durchschnittliche Leistung (Pmoy) des digitalen Signals (Sig-out) darstellt.

8. Verfahren nach Anspruch 6 oder 7, wobei das Verstärkungseinstellungsinkrement ginc gemäß der Formel berechnet wird:

$$ginc = \frac{Pref - Plog}{[1dB]}$$

wobei Pref eine Referenzleistung ist.

9. Verfahren nach Anspruch 8, wobei die Referenzleistung (Pref) als eine Funktion der maximalen Leistung bestimmt wird, die durch das digitale Signal (Sig-out) erreicht wird.

10. Verfahren nach einem der Ansprüche 1 bis 9, bei dem die Empfangskette (10) in Paketen übertragene Daten empfängt.

11. Verfahren nach einem der Ansprüche 1 bis 10, bei dem die Verstärkung (g) des Verstärkers (12) nach einer einzigen Iteration eingestellt wird.

12. Verfahren nach einem der Ansprüche 1 bis 11, bei dem der Verstärkungsfaktor (g) des Verstärkers (12) nach mindestens einer Iteration eingestellt wird.

13. Verfahren nach Anspruch 12, bei dem die Anzahl der Iterationen gleich eins oder zwei ist.

**EP 3 595 171 B1**

**Claims**

1. A calibration method for calibrating a reception chain (10) comprising an input amplifier (12) of an analogue-to-digital converter (14), and comprising the following successive steps:

   determining a rest gain (grepos) as a function of the average power of the noise present on a digital signal (Sig-out) from said converter (14); and
   setting the gain (g) of the input amplifier (12) at said rest gain (grepos) when the average power (Pmoy) of said digital signal (Sig-out) is lower than a first threshold (Th0),
   wherein the gain (g) is adjusted by adding a gain adjustment increment (ginc) determined as a function of the average power of the digital signal (Sig-out) when the average power (Pmoy) of the digital signal (Sig-out) is greater than a second threshold (Th1).

2. The method according to claim 1, wherein, in order to calculate the gain adjustment increment (ginc), the average power (Pmoy) of the digital signal (Sig-out) is calculated as a function of a linear power (Plin) of the digital signal (Sig-out).

3. The method according to claim 2, wherein the linear power Plin is calculated in accordance with the formula:

$$Plin = \frac{I^2 + Q^2}{K}$$

   wherein:

   I is the imaginary part of the digital signal (Sig-out);
   Q is the real part of the digital signal (Sig-out); and
   K is a factor conditioning the number of bits on which the linear power Plin is encoded.

4. The method according to claim 3, wherein the number K designates the least significant bits for which the average power (Pmoy) of the digital signal (Sig-out) is not measurable.

5. The method according to any of claims 1 to 4, wherein the average power (Pmoy) is calculated using an infinite impulse-response filter.

6. The method according to any of claims 1 to 5, wherein the average power (Pmoy) is converted into a logarithmic average power Plog.

7. The method according to claim 6, wherein the logarithmic average power Plog is obtained from a table the elements of which are calculated in accordance with the formula:

$$Plog = \frac{2^{N'} - 1}{\ln(2^{N'} - 1)} \ln(Pmoy)$$

   wherein N' is the number of bits on which the logarithmic average power (Plog) is encoded; and
   Pmoy represents the average power (Pmoy) of the digital signal (Sig-out).

8. The method according to claim 6 or 7, wherein the gain adjustment increment ginc is calculated in accordance with the formula:

$$ginc = \frac{Pref - Plog}{[1dB]}$$

   where Pref is a reference power.

9. The method according to claim 8, wherein the reference power (Pref) is determined as a function of the maximum power reached by the digital signal (Sig-out).

10. The method according to any of claims 1 to 9, wherein the reception chain (10) receives data transmitted in packets.

11. The method according to any of claims 1 to 10, wherein the gain (g) of the amplifier (12) is adjusted after a single iteration.

12. The method according to any of claims 1 to 11, wherein the gain (g) of the amplifier (12) is adjusted after at least one iteration.

13. The method according to claim 12, wherein the number of iterations is equal to one or two.

Fig 1

Fig 2

Fig 3

107A — Pmoy

107B — Plog

107C — ginc

107D — g

107E — x-num(g)

Fig 4

bits

X

M

N

Pref

K

O

Fig 5

**EP 3 595 171 B1**

## RÉFÉRENCES CITÉES DANS LA DESCRIPTION

### Documents brevets cités dans la description

- US 2006145902 A1